Europäisches Patentamt

(19) European Patent Office

Office européen des brevets

(11) Numéro de publication : **0 106 724**
**B1**

(12) **FASCICULE DE BREVET EUROPÉEN**

(45) Date de publication du fascicule du brevet :
07.06.89

(21) Numéro de dépôt : 83401740.2

(22) Date de dépôt : 02.09.83

(51) Int. Cl.⁴ : **H 01 L 29/72**, H 01 L 29/36, H 01 L 29/10

(54) Transistor bipolaire balistique à hétérojonction.

(30) Priorité : 17.09.82 US 419293

(43) Date de publication de la demande :
25.04.84 Bulletin 84/17

(45) Mention de la délivrance du brevet :
07.06.89 Bulletin 89/23

(84) Etats contractants désignés :
DE FR GB IT NL

(56) Documents cités :
EP—A— 0 042 489
TECHNICAL DIGEST OF THE INTERNATIONAL ELEC-
TRON DEVICES MEETING, tenu à Washington,
décembre 7-9, 1981, pages 629-632, publié IEEE, New
York, US; P.M. ASBECK et al.: "(Ga,Al)As/GaAs bipo-
lar transistors for digital integrated circuits";
PROCEEDINGS OF THE EIGHTH BIENNIAL CORNELL
ELECTRICAL ENGINEERING CONFERENCE, tenu à
Cornell University, Ithaca, New York, août 11-13,
1981, pages 87-95, publié IEEE, New York, US; R.J.
MALIK et al.: "GaAs planar-doped barrier transistors
grown by molecular beam epitaxy"
PROCEEDINGS OF THE IEEE, vol. 70, no. 1, janvier
1982, pages 13-25, New York, US; H. KROEMER:
"Heterostructure bipolar transistors and integrated
circuits"
PROCEEDINGS OF THE EIGHTH BIENNAL CORNELL
ELECTRICAL ENGINEERING CONFERENCE, tenu à
Cornell University, Ithaca, New York, août 11-13,
1981, pages 65-74, publié IEEE, New York, US; L.F.
EASTMAN: "Limits of ballistic electron motion in
compound semiconductors"

(73) Titulaire : ETAT FRANCAIS représenté par le Ministre
des PTT (Centre National d'Etudes des Télécommuni-
cations)
38-40 rue du Général Leclerc
F-92131 Issy-les-Moulineaux (FR)

(72) Inventeur : Ankri, David G.
112, rue de Briançon
F-75015 Paris (FR)
Inventeur : Eastman, Lester F.
61 Burdick Hill Rd.
Ithaca New York 14850, N.Y. (US)
Inventeur : Ku, Walter H.
330 The Parkway
Ithaca New York 14850 (US)

(74) Mandataire : Mongrédien, André et al
c/o BREVATOME 25, rue de Ponthieu
F-75008 Paris (FR)

Jouve, 18, rue St-Denis, 75001 Paris, France

IEEE ELECTRON DEVICE LETTERS, vol. EDL-1, no. 4, avril 1980, page 54, New York, US; T.J. MALONEY: "Polar mode scuttering in ballistic transport GaAs devices"
Le dossier contient des informations techniques présentées postérieurement au dépôt de la demande et ne figurant pas dans le présent fascicule.

## Description

La présente invention se rapporte d'une façon générale aux composants semi-conducteurs à trois bornes comme les transistors bipolaires, les transistors à base perméable, les transistors planar à barrière dopée, et plus particulièrement, à un composant dans lequel la barrière émetteur-base est réalisée de manière à permettre un mouvement des électrons quasi-balistique. Un tel composant est capable de fonctionner à très grande vitesse.

Dans un composant semi-conducteur à structure « verticale », par exemple, où un courant circule de l'émetteur vers le collecteur à travers la base et où l'intensité du courant est modulée par le courant de base ou la tension de base, des limitations apparaissent dans les plages des fréquences les plus élevées, en raison du mécanisme de diffusion par lequel les porteurs de charge se déplacent dans le composant. Il est connu que les limitations par diffusion peuvent être réduites en diminuant l'épaisseur de la région de base mais cette réduction augmente aussi de façon indésirable la résistance de base. De plus, cette diminution d'épaisseur n'élimine pas entièrement les limitations dues à la diffusion car, dans un composant hétérojonction bipolaire ordinaire, les électrons sont injectés dans la région de base avec une faible énergie thermique (environ 26 meV) ; ainsi, la production de signaux à haute fréquence, dans de tels composants, particulièrement dans la plage des hyperfréquences, n'est-elle pas entièrement satisfaisante.

Le brevet des Etats-Unis d'Amérique n° 3 209 215 est un brevet ancien qui décrit des composants semi-conducteurs à hétérojonction dans lesquels une région de base étroite est prévue, mais dans lesquels l'émetteur, la base et le collecteur présentent un même type de conductivité. Ce brevet décrit une structure dans laquelle se produisent des effets tunnel mais aucune mention n'est faite à l'utilisation d'une triode hétérojonction avec une base dont la conductivité est opposée à celle des autres électrodes.

Le brevet des Etats-Unis d'Amérique n° 4 286 275 décrit également un composant semi-conducteur à trois bornes et il est orienté vers une réalisation destinée à obtenir une vitesse de commutation accrue. Ce brevet reconnaît les limitations du mouvement par diffusion des porteurs de charge et résout ce problème en choisissant la hauteur et la largeur de barrière pour l'émetteur (ou région d'injection des porteurs) de manière à ce que le mécanisme d'injection de courant prédominant soit l'effet tunnel.

Le brevet des Etats-Unis d'Amérique n° 4 173 763 décrit également un transistor à hétérojonction dans lequel une épaisseur de base de 10 nm (100 Å) ou moins est utilisée pour produire un effet tunnel depuis l'émetteur vers le collecteur, afin d'obtenir un composant fonctionnant à grande vitesse.

Ces brevets antérieurs montrent que les limitations apportées par le mécanisme de diffusion sont connues et que des tentatives ont été faites pour les pallier, à l'aide de diverses structures aptes à produire des transistors qui fonctionnent à des fréquences élevées. Mais cette technique antérieure ne suggère pas qu'un mouvement balistique ou quasi-balistique des porteurs puisse être utilisé pour améliorer la vitesse de fonctionnement.

Bien qu'un mouvement balistique dans la base mince d'un transistor bipolaire à l'arséniure de gallium soit suggéré par Rohr et al (Solid State Electronics 17, page 729, 1974), il n'est pas tenu compte du fait qu'un mouvement à haute énergie peut conduire à des effets de diffusion, dans lesquels les électrons sont diffusés vers des vallées d'énergie supérieures ; il n'a pas été observé non plus que des barrières de potentiel peuvent être utilisées pour lancer des électrons et il n'est pas prévu que ce mouvement puisse être utilisé pour résoudre le problème de limitation par diffusion, afin d'obtenir un fonctionnement à grande vitesse. Un composant conforme au préambule de la revendication 1 est connu de l'exposé de P. M. Asbeck et al, publié dans « Technical Digest of the International Electron Devices Meeting », December 7-9, 1981, pages 629-632, et de l'article de H. Kroemer dans « Proceedings of the IEEE », vol. 70, janvier 1982, pages 13-25.

Un objet de l'invention est donc de proposer un composant semi-conducteur bipolaire à hétérojonction, à trois bornes et à grande vitesse de fonctionnement, qui évite les limitations dues au mécanisme de diffusion.

Un autre objet de l'invention est de proposer un transistor bipolaire balistique à hétérojonction comprenant une région de base de conductivité opposée à celle des régions d'émetteur et de collecteur et dans lequel l'épaisseur de la région de base est de l'ordre de la longueur du libre parcours moyen des porteurs minoritaires, les porteurs étant injectés par l'émetteur vers la région de base au moyen d'une barrière de potentiel résultant du caractère hétérogène de la jonction émetteur-base.

Un autre objet de l'invention est de proposer un transistor bipolaire hétérojonction à grande vitesse dans lequel les limitations dues au mécanisme de diffusion sont éliminées grâce à une barrière d'interface émetteur-base qui sert à accélérer des électrons jusqu'à des énergies voisines de, mais inférieures à, l'énergie de dispersion vers les vallées d'énergie supérieures.

Un autre objet de l'invention est de proposer un transistor bipolaire balistique à hétérojonction comprenant une barrière émetteur-base qui permet un mouvement quasi-balistique des électrons sans diffusion.

En résumé, l'invention concerne un composant semi-conducteur bipolaire à hétérojonction comprenant des régions d'émetteur, de base et de collecteur, la jonction émetteur-base pouvant être une jonction GaAlAs-GaAs, ou pouvant être formée d'autres composés III-V. Le composant est formé de manière à ce que la différence de mobilité des électrons entre l'émetteur et la base crée une barrière de potentiel en forme de « crête » au bord de la bande de conduction. Cette crête produit une chute de potentiel pour les électrons qui franchissent la barrière et elle est utilisée pour accélérer les électrons jusqu'à des niveaux d'énergie proches de, mais inférieurs à, ceux qui entraînent une diffusion vers les vallées supérieures (principalement par interaction de phonons polaro-optiques). L'énergie de diffusion dans GaAs est inférieure ou égale à $\Delta E_{T-L} = E_T - E_L = 0,31$ eV, où $E_T$ est le niveau d'énergie pour la vallée centrale et $E_L$ le niveau d'énergie pour la vallée supérieure. Pour GaInAs, $\Delta E_{T-L} = 0,56$ eV. En utilisant un niveau d'énergie au-dessous du niveau de diffusion, un mouvement quasi-balistique des électrons est produit, de sorte que les électrons peuvent traverser une mince région de base presque sans collision, ce mouvement se produisant à l'intérieur de la région de base plutôt qu'à la surface, où des effets antagonistes peuvent apparaître. Cela permet à la structure verticale de tirer pleinement profit des vitesses élevées données aux électrons, et conduit à un temps de transit émetteur-collecteur situé dans une plage au-dessous de la pico-seconde. La crête de la bande de conduction à la jonction émetteur-base est choisie de manière à ce que sa hauteur permette une émission thermo-ionique d'électrons au-dessus de la crête, les électrons étant accélérés jusqu'à une énergie cinétique dans la plage de dix fois l'énergie thermique. Cette énergie cinétique est de préférence environ dix pour cent inférieure à l'énergie nécessaire pour transférer les électrons jusqu'à la vallée supérieure, et produit ainsi une vitesse maximale des électrons et une longueur maximale pour le libre parcours moyen (voisin de 0,15 $\mu$m pour 0,3 eV). A ce niveau d'énergie, les électrons se déplacent par dérive plutôt que par diffusion, ce qui réduit les collisions avec les impuretés dans la matière. Si des collisions se produisent pour certains des électrons injectés, les conséquences sont mineures et l'énergie n'est réduite que d'un peu plus de 10 pour cent. De même, la plage d'angle de déviation peut être faible (5 à 10°) de sorte que la direction souhaitée pour la vitesse des électrons n'est pas sérieusement affectée.

La largeur, et plus généralement la forme, de la région de crête (région dite d'interface) est choisie pour éviter l'effet tunnel à travers la barrière complète, afin que la majorité des électrons puisse être accélérés jusqu'à l'énergie appropriée (et non une énergie inférieure). La forme est également ajustée pour réduire la réflexion quantique des électrons qui sont injectés ; ainsi, la pente de la crête doit être plus faible du côté de l'émetteur que du côté de la base.

Pour un semi-conducteur GaAs, l'énergie d'injection thermique est d'environ 0,026 eV. Si la région d'interface entre l'émetteur et la base a une épaisseur de 10 nm (100 Å) par exemple, le champ est égal à $0,26$ eV/100 Å $= 2,6 \times 10^5$ V/cm, ce qui produit la vitesse voulue des électrons. Bien que d'autres composés semi-conducteurs III-V conduisent à une énergie d'injection thermique différente et que différentes épaisseurs d'interface donnent des résultats différents, le principe reste le même.

En plus de la forme de la région d'interface, il existe d'autres facteurs permettant de régler la vitesse des électrons ; ce sont la largeur de la région de base et les concentrations en impuretés dans le semi-conducteur. Ainsi, en modifiant ces facteurs, il est possible d'obtenir un brusque gradient de champ dans les zones d'interface (c'est-à-dire dans les zones situées entre une région homogène en GaAs et une région homogène en GaAl) ou d'obtenir un gradient progressif, ce qui permet d'obtenir des crêtes de différentes formes et de différentes hauteurs. Avec un gradient brusque, la région d'interface peut avoir une largeur de 1,5 nm (15 Å) tandis que dans le cas d'un gradient progressif, la largeur d'interface peut être comprise entre 1,5 nm (15 Å) et 10 nm (100 Å).

Des transistors ayant ces caractéristiques peuvent être réalisés par des techniques de diffusion ou d'implantation dans une structure quasi-planar, avec des structures mésa ou autres.

D'autres caractéristiques et avantages de l'invention apparaîtront au cours de la description qui va suivre, de plusieurs exemples de réalisation se référant aux dessins annexés sur lesquels :

la figure 1 est un diagramme de bande d'énergie pour un composant semi-conducteur à trois bornes comportant une hétérojonction abrupte selon une forme préférée de l'invention,

la figure 2 est un diagramme de bande d'énergie pour le composant de la figure 1 avec une polarisation directe,

la figure 3A est un diagramme de bande d'énergie d'une hétérojonction de semiconducteur dans le cas d'un second mode de réalisation,

la figure 3B est un diagramme de bande d'énergie d'une hétérojonction selon un troisième mode de réalisation,

les figures 4A et 4B sont des diagrammes de bande d'énergie selon un quatrième et un cinquième mode de réalisation,

la figure 5 est un diagramme de bande d'énergie selon un sixième mode de réalisation,

la figure 6 représente schématiquement une structure de transistor quasi-planar selon l'invention,

les figures 7A à 7D sont des représentations schématiques de la fabrication d'une structure de transistor mésa, et

les figures 8A et 8B sont des représentations schématiques d'autres formes de structure de transistor selon l'invention.

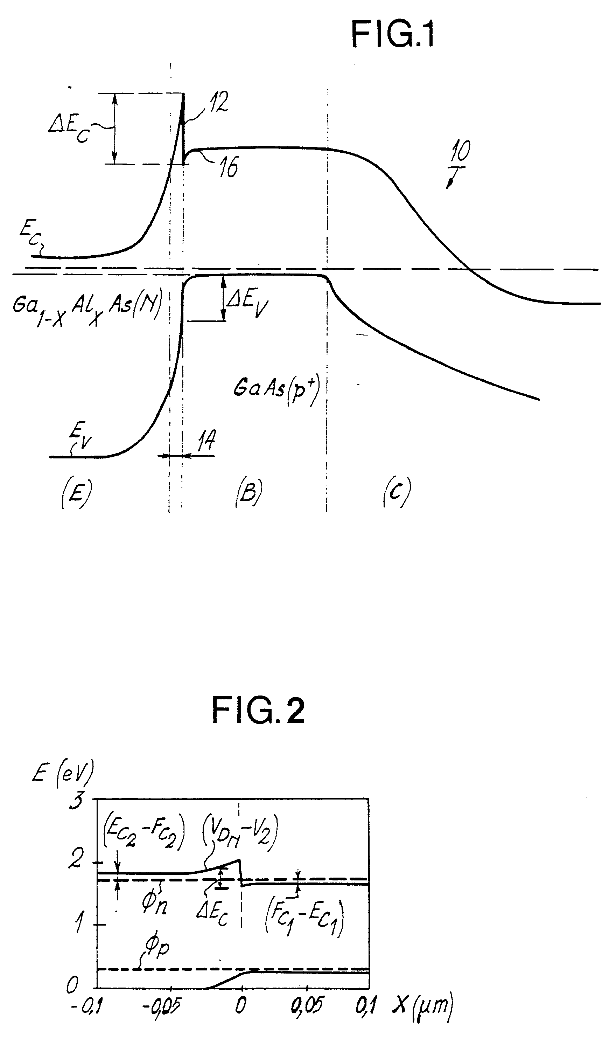

Pour passer maintenant à un examen plus détaillé des dessins, la figure 1 illustre en 10 la bande d'énergie d'un composant semi-conducteur à trois bornes, comme un transistor bipolaire comprenant une région d'émetteur (E), une région de base (B) et une région de collecteur (C). La bande de conduction montre en 12 une crête ou barrière de hauteur $\Delta E_c$, crête qui est formée à l'interface 14 ou hétérojonction, entre l'émetteur et la base. L'émetteur est un semi-conducteur GaAlAs de type N. L'énergie de la bande de conduction est notée $E_c$, celle de la bande de valence $E_v$ et leurs variations $\Delta E_c$ et $\Delta E_v$. Dans ce composant, la polarisation est nulle et $\Delta E_c \simeq 0,85\ \Delta E_g$, et $\Delta E_v = 0,15\ \Delta E_g$, où $E_g$ est la largeur de l'intervalle (gap) entre les bandes de conduction et de valence et $\Delta E_g$ la différence de largeur de « gap » entre émetteur et base. Ce diagramme montre une variation brusque du niveau d'énergie ; dans ce cas, la jonction pn coïncide avec la jonction métallurgique. Etant donné que le transistor bipolaire à hétérojonction représenté met en œuvre un niveau de dopage pour la base qui est beaucoup plus élevé que celui de l'émetteur, la différence d'énergie ($\Delta E_c$) dans la région 12 de crête est très proche de la hauteur de la barrière, la pointe négative de potentiel 16, dans la base, étant négligeable.

Etant donné que la hauteur de la crête doit être égale ou inférieure à l'énergie de diffusion $\Delta E_{T-L}$, égale à 0,31 eV, la plage de teneur en aluminium dans l'émetteur peut être déterminée à partir de l'équation suivante

$$\Delta E_c = (1,06 \pm 0,03)\ X_{Al}$$

pour des valeurs de $X_{Al} \leqslant 0,45$, où $X_{Al}$ est la teneur en aluminium dans l'émetteur. Ainsi, si $\Delta E_c$ est établie autour de 0,26 eV (qui est inférieur au niveau d'énergie de diffusion pour la composition définie ci-dessus), la teneur en aluminium est environ 25 %.

En même temps, une polarisation directe appropriée (Va) doit être établie, produisant des niveaux d'énergie illustrés sur la figure 2, où

$$V_a = V_D — \Delta E_c$$

$$V_a = E_{gB} — \delta_E — \delta_B$$

où $V_D$ est le potentiel établi dans le semi-conducteur à la jonction émetteur-base et $\delta_E — \delta_B$ est la différence d'énergie entre la bande de conduction (bande de valence) et le niveau de Fermi.

La largeur de la région de crête 12 dépend du niveau de dopage de la région appropriée de l'émetteur. Dans ce cas, le niveau de dopage doit être d'environ $2 \times 10^{16}$ cm⁻³ et à cette valeur, avec $V_a = 1,3$ V, la largeur d'appauvrissement dans la région d'émetteur est $W_n = 50$ nm (500 Å), tandis que pour ces valeurs, l'effet tunnel pourrait être gênant même avec une largeur d'environ 16 nm (160 Å).

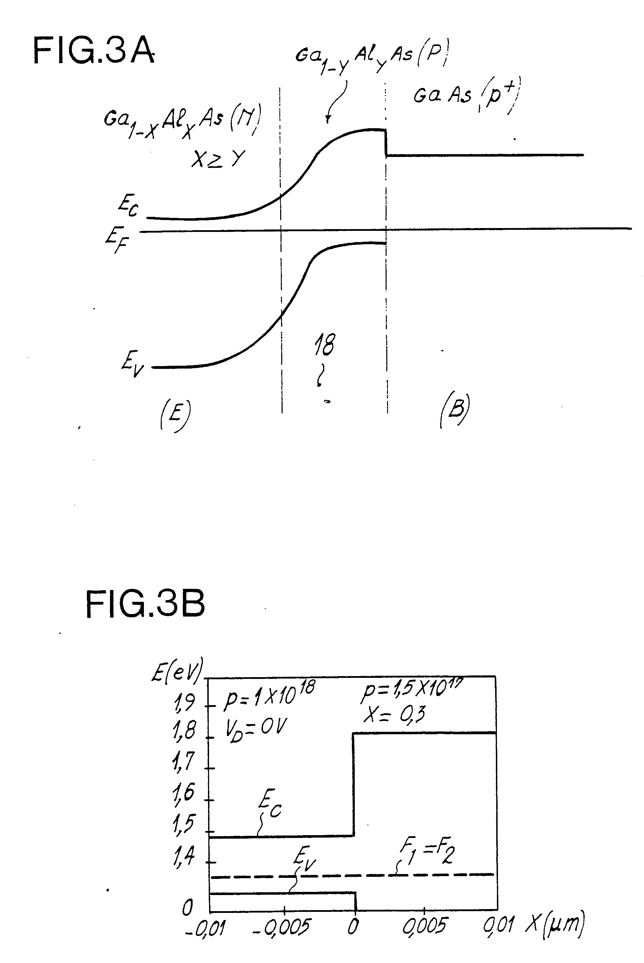

La largeur de la barrière de potentiel peut être réglée, comme le montrent les figures 3A et 3B, en déplaçant la jonction électrique par rapport à la jonction métallurgique GaAlAs-GaAs, en plaçant une mince matière d'interface 18 entre les régions d'émetteur et de base. La matière 18 est une couche de GaAlAs de type p⁻ convenablement dopée et son épaisseur est facilement réglable, permettant ainsi un réglage facile de la largeur de la région de crête.

Le niveau de dopage du matériau de type p⁻ est choisi de manière que la couche 18 soit complètement appauvrie en fonctionnement normal, que le courant d'injection d'électrons dépende principalement de la concentration des porteurs minoritaires de la région de base GaAs et que, par conséquent, l'efficacité d'injection soit encore élevée. Dans ce cas, le niveau de dopage de l'émetteur peut être supérieur, par exemple $10^{17}$ cm⁻³.

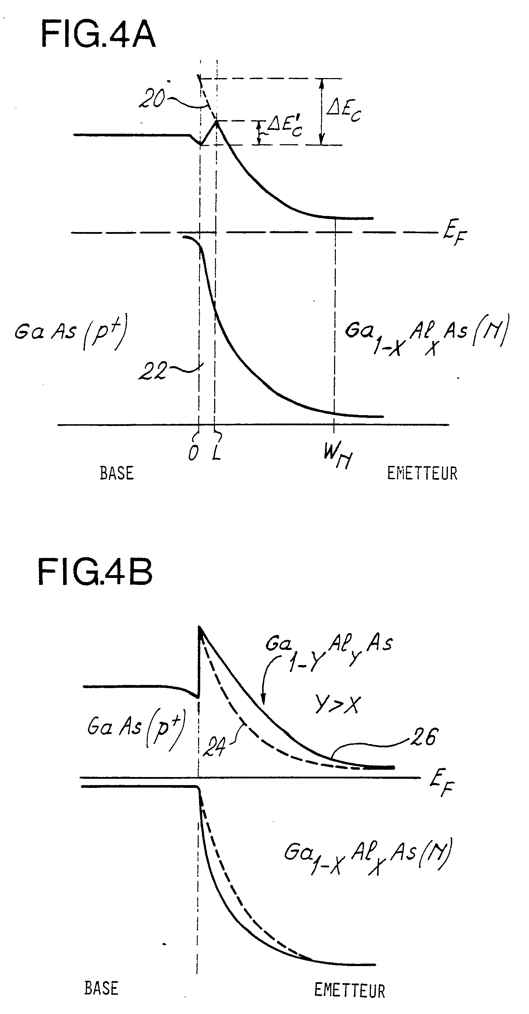

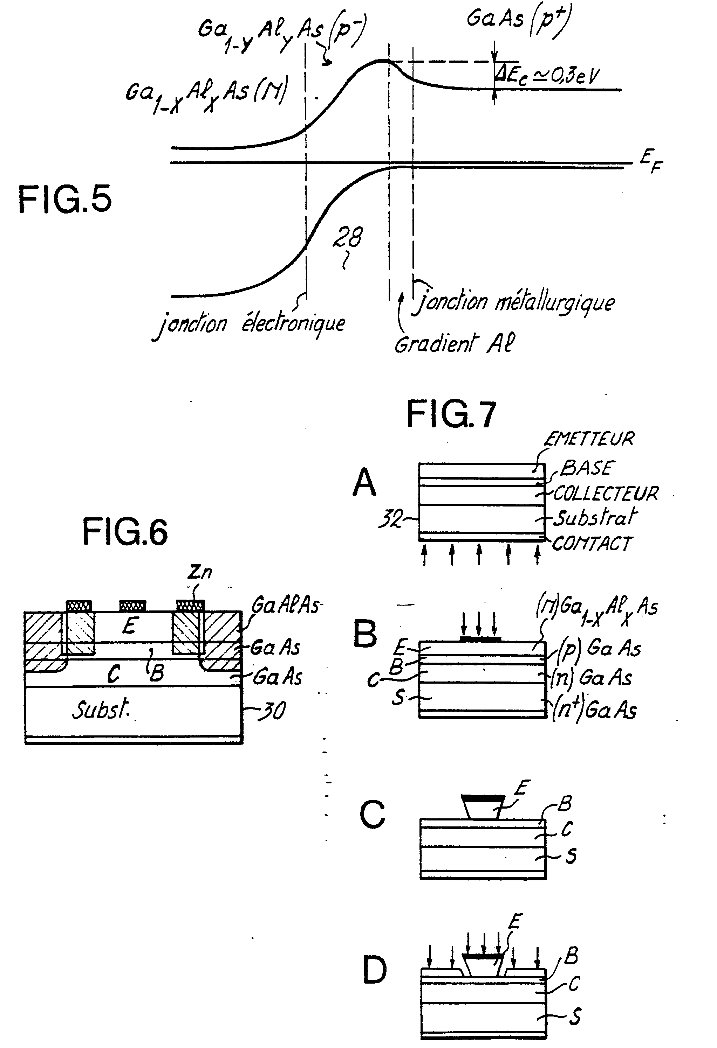

Les bandes d'énergie pour des interfaces abruptes courantes, donnant des crêtes d'hétérojonction plus progressives, sont représentées schématiquement sur les figures 4A et 4B et 5. Dans ces régions, le gradient d'aluminium est modifié à la région d'interface afin de régler la hauteur de barrière $\Delta E_c$ à la valeur voulue. Ainsi, la figure 4A montre une hétérojonction de type GaAlAs (N)-GaAs (p⁺) similaire à celle illustrée par la figure 1. Mais dans ce cas, la crête prévue 20, ayant une valeur $\Delta E_c$, est réglée à $\Delta E'_c$ en modifiant la teneur en aluminium dans la région d'interface 22. Cette variation de concentration d'aluminium entraîne une variation du champ et permet de modifier la forme et la hauteur de la crête. La figure 4A montre une crête plus basse ayant des pentes linéaires, mais des courbes de forme plus complexe peuvent être retenues. La hauteur de la barrière effective peut être proche de 0,3 eV même si $X_{Al} \geqslant 0,3$.

Une bande d'énergie pour une autre hétérojonction GaAlAs (N)-GaAs (p⁺) est représentée sur la figure 4B. Dans ce cas, la teneur en aluminium de la couche d'émetteur est augmentée dans la couche d'appauvrissement et réduite à l'interface, changeant ainsi la courbe de potentiel 24 prévue en une nouvelle courbe 26 et en produisant la valeur voulue de la tension de barrière.

La fabrication des hétérojonctions des figures 4A et 4B, pour permettre des variations de la teneur en aluminium de la matière d'émetteur, peut être contrôlée facilement en utilisant, par exemple, une croissance épitaxiale par faisceau moléculaire afin d'obtenir les valeurs appropriées des hauteurs et des largeurs de la région de crête. Mais en apportant ces modifications, des précautions doivent être prises pour maintenir la valeur maximale de la crête au-dessous de l'énergie provoquant le transfert des électrons vers la vallée supérieure, pour mettre en forme la crête afin de réduire au minimum les déviations et pour éviter l'effet tunnel.

Dans un composant du type illustré sur la figure 3A, la teneur en aluminium de la région d'émetteur GaAlAs de type N peut être supérieure à 30 %, allant généralement jusqu'à 45 %. Une légère interface progressive peut être obtenue (voir figure 5) entre la couche d'émetteur et une mince couche 28 de

5

GaAlAs de type p⁻ entre l'émetteur et la base, cette couche servant à déplacer la jonction électrique par rapport à la jonction métallurgique, comme déjà décrit. Cette interface peut conduire à un $X_{Al} > 0,30$ entre les couches N et p⁻. A la jonction suivante, entre la couche 28 (p⁻) et la couche en GaAs (p⁺) de la base, la teneur en aluminium peut être réduite sur une courte distance afin d'obtenir un champ élevé.

La fabrication de transistors balistiques à hétérojonction ayant les caractéristiques décrites ci-dessus, peut s'effectuer comme le montrent les figures 6 à 8. La figure 6 illustre une structure 30 de transistor quasi-planar du type illustré dans le brevet français 78 26 069. Cette structure peut être obtenue soit par implantation, soit par diffusion, pour mettre le contact de base sur le même plan que celui de l'émetteur, par une région de type p⁺, et cela de la manière connue, le dopage et la largeur des interfaces étant réglés pour obtenir les caractéristiques décrites ci-dessus.

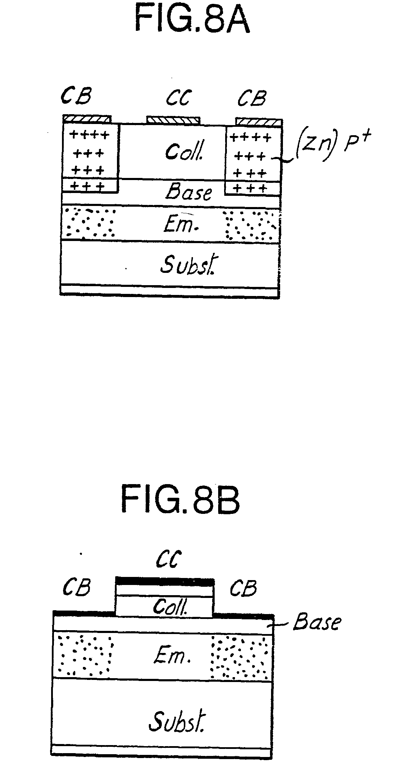

Une structure mésa du type illustré sur la figure 7 (A à D) peut être utilisée, et convient particulièrement pour des interfaces progressives du type décrit en liaison avec la figure 4B où $X_{AlAs} \geqslant 40\ \%$. La fabrication d'un transistor mésa tel que le transistor 32 est connue dans l'art antérieur.

Une autre structure utilisant une couche d'émetteur à la partie inférieure est illustrée sur la figure 8A. Dans ce composant, l'inductance d'émetteur peut être réduite à des valeurs faibles, qui conviennent pour un fonctionnement à haute fréquence. Cette structure peut utiliser une région implantée de type p⁺ comme contact de base (CB) sur le même plan que le contact de collecteur (CC). Une seconde implantation (isolement utilisant des protons, de l'oxygène ou du bore pour GaAs) peut être utilisée pour réduire la capacité latérale d'émetteur (zone en pointillé).

La même structure de transistor avec émetteur à la partie inférieure peut aussi être réalisée par mésa comme le montre la figure 8. La région de base peut être obtenue par gravure et une structure auto-alignée peut être utilisée pour mettre très étroitement en contact la base et le collecteur. Une implantation d'isolement de la couche d'émetteur (zone en pointillé) au-dessous du contact de base peut réduire la capacité parasite entre l'émetteur et la base.

Le composant semi-conducteur à hétérojonction selon l'invention, formé à partir de composés du groupe III-V peut être fabriqué par des procédés de croissance épitaxiale. En particulier, cela englobe les composés GaAlAs-GaAs ; InP-GaInAs ; AlGaAsIn-GaInAs ; et AlInAs-GaInAs, des couples d'autres matières pouvant être considérés à des températures de l'azote liquide, comme GaSb-AlSb ou InSb-cdTe.

Bien entendu, de nombreuses modifications peuvent être apportées aux modes de réalisation décrits et illustrés à titre d'exemples nullement limitatifs, sans sortir du cadre de l'invention.

## Revendications

1. Composant semi-conducteur bipolaire à hétéro-jonction fonctionnant à grande vitesse, comprenant :

une base (B) en un premier semi-conducteur ayant une bande interdite et un dopage d'un premier type,

un émetteur (E) en un second semi-conducteur ayant une bande interdite de largeur supérieure à la bande interdite de la base, et un dopage d'un second type opposé au premier, le dopage de l'émetteur étant plus faible que le dopage de la base,

un collecteur (C) en un troisième semi-conducteur ayant un dopage du type de celui de l'émetteur,

une hétéro-jonction émetteur-base présentant une bande de conduction en forme de crête avec une pente progressive côté émetteur et une pente abrupte côté base, cette crête permettant, lorsqu'une tension de polarisation directe est appliquée entre émetteur et base, de lancer les porteurs de charge de l'émetteur dans la base, avec une énergie cinétique élevée,

ce composant étant caractérisé par le fait qu'il comprend, au niveau de l'hétéro-jonction émetteur-base, une interface (14, 18, 22, 28) dont la composition et le dopage ont pour effet de donner à la crête une largeur supérieure à (16 nm) 160 Å pour éviter que les porteurs ne la traversent par effet tunnel et une hauteur supérieure à environ dix fois l'énergie thermique normale des porteurs dans ledit semi-conducteur et inférieure à l'énergie de diffusion desdits porteurs.

2. Composant selon la revendication 1, caractérisé par le fait que l'interface est constituée par une couche (8) d'un semi-conducteur ayant un dopage du type de celui de la base, mais moins dopé que celle-ci.

3. Composant selon la revendication 1 ou 2, caractérisé par le fait que l'interface est constituée par un troisième semi-conducteur analogue au deuxième semi-conducteur de l'émetteur mais de composition légèrement différente.

4. Composant selon la revendication 1, caractérisé par le fait que le semi-conducteur de la base est en GaAs, la hauteur de la crête étant comprise entre 0,26 et 0,30 eV:

5. Composant selon la revendication 1, caractérisé par le fait que le semi-conducteur de la base est du GaInAs, la hauteur de la crête étant comprise entre 0,20 et 0,50 eV.

6. Composant selon la revendication 1, caractérisé par le fait que l'hétéro-jonction émetteur-base est constituée par un couple de semi-conducteurs pris dans le groupe comprenant les couples GaAlAs-GaAs ; InP-GaInAs ; AlGaInAs-GaInAs ; et AlInAs-GaInAs.

**Claims**

1. Heterojunction bipolar semiconductor component operating at high speed comprising :

a base (B) in a first semiconductor having a forbidden band and a doping of a first type,

an emitter (E) in a second semiconductor having a wider forbidden band than that of the base and a doping of a second type opposed to the first, the emitter doping being weaker than the base doping,

a collector (C) in a third semiconductor having a doping of the same type as the emitter,

an emitter — base heterojunction having a peak or spike form conduction band with a progressive slope on the emitter side and an abrupt slope on the base side, said spike making it possible, when a forward biasing voltage is applied between the emitter and the base, to introduce the charge carriers of the emitter into the base with a high kinetic energy,

said component being characterized in that it comprises at the emitter — base heterojunction, an interface (14, 18, 22, 28), whose composition and doping have the effect of giving the spike a width greater than (16 nm 160 Å) to prevent the carriers traversing it by the tunnel effect and a height greater than approximately 10 times the normal thermal energy of the carriers in said semiconductor and below the diffusion energy of said carriers.

2. Component according to claim 1, characterized in that the interface is constituted by a layer (8) of a semiconductor having a doping of the type of that of the base, but less doped than the latter.

3. Component according to claims 1 or 2, characterized in that the interface is constituted by a third semiconductor identical to the second semiconductor of the emitter, but with a slightly different composition.

4. Component according to claim 1, characterized in that the semiconductor of the base is of GaAs, the height of the spike being between 0.26 and 0.30 eV.

5. Component according to claim 1, characterized in that the semiconductor of the base is of GaInAs, the height of the spike being between 0.20 and 0.50 eV.

6. Component according to claim 1, characterized in that the emitter — base heterojunction is constituted by a pair of semiconductors taken from the group of pairs GaAlAs-GaAs ; InP-GaInAs ; AlGaInAs-GaInAs ; and AlInAs-GaInAs.

**Patentansprüche**

1. Bipolares Halbleiterbauelement mit Heteroübergang, der mit großer Geschwindigkeit arbeitet, enthaltend :

eine Basis (B) aus einem ersten Halbleiter, der ein verbotenes Band und eine Dotierung eines ersten Typs aufweist,

einen Emitter (E) aus einem zweiten Halbleiter, der ein verbotenes Band größerer Abmessung als das verbotene Band der Basis aufweist, und eine Dotierung eines zweiten, zum ersten entgegengesetzten Typs aufweist, wobei die Dotierung des Emitters schwächer als die Dotierung der Basis ist,

einen Kollektor (C) aus einem dritten Halbleiter, der eine Dotierung vom gleichen Typ wie der Emitter aufweist,

eine Heteroverbindung Emitter/Basis, die ein Leitfähigkeitsband in Form eines Sattels aufweist mit einem progressiven Abfall auf der Seite des Emitters und einem abrupten Abfall auf der Seite der Basis, welcher Sattel es erlaubt, bei Anlegung einer Polarisationsgleichspannung zwischen den Emitter und die Basis Ladungsträger

vom Emitter in die Basis mit erhöhter kinetischer Energie zu stoßen, wobei das Bauelement durch die Tatsache gekennzeichnet ist, daß es in Höhe der Heteroverbindung Emitter/Basis eine Grenzfläche (14, 18, 22, 28) aufweist, deren Zusammensetzung und Dotierung zur Folge haben, daß dem Sattel eine Dicke von mehr als 16 nm (160 Å) gegeben wird, um zu vermeiden, daß die Ladungsträger ihn durch Tunneleffekt durchqueren, und eine Höhe von mehr als etwa dem 10fachen der normalen thermischen Energie der Ladungsträger in dem genannten Halbleiter und weniger als der Diffusionsenergie der genannten Ladungsträger.

2. Bauelement nach Anspruch 1, gekennzeichnet durch die Tatsache, daß die Grenzfläche von einer Schicht (8) eines Halbleiters gebildet ist, der eine Dotierung vom selben Typ wie die Basis aufweist, jedoch weniger dotiert ist, als diese.

3. Bauelement nach Anspruch 1 oder 2, gekennzeichnet durch die Tatsache, daß die Grenzfläche von einem dritten Halbleiter analog dem zweiten Halbleiter des Emitters, aber von leicht unterschiedlicher Zusammensetzung gebildet ist.

4. Bauelement nach Anspruch 1, gekennzeichnet durch die Tatsache, daß der Halbleiter der Basis aus GaAs besteht und die Höhe des Sattels zwischen 0,26 und 0,30 eV liegt.

5. Bauelement nach Anspruch 1, gekennzeichnet durch die Tatsache, daß der Halbleiter der Basis aus GaInAs besteht, wobei die Höhe des Sattels zwischen 0,20 und 0,50 eV liegt.

6. Bauelement nach Anspruch 1, gekennzeichnet durch die Tatsache, daß die Heteroverbindung Emitter/Basis von einem Halbleiterpaar gebildet wird, das der Gruppe entnommen wird, die folgende Paarungen enthält GaAlAs-GaAs ; InP-GaInAs ; AlGaInAs-GaInAs ; und AlInAs-GaInAs.

# FIG.1

$\Delta E_C$

12

16

10

$E_C$

$Ga_{1-X} Al_X As(N)$

$\Delta E_V$

$GaAs(p^+)$

$E_V$

14

(E)　　　　(B)　　　　(C)

# FIG.2

$E\ (eV)$

3

$(E_{C_2} - F_{C_2})$　$(V_{D_H} - V_2)$

2

$\phi_n$　$\Delta E_C$　$(F_{C_1} - E_{C_1})$

1

$\phi_p$

0

-0,1　　-0,05　　0　　0,05　　0,1　$X\ (\mu m)$

1

# FIG.3A

$Ga_{1-y} Al_y As (P)$

$Ga_{1-x} Al_x As (N)$

$X \geq Y$

$Ga As (p^+)$

$E_C$

$E_F$

$E_V$

18

$(E)$

$(B)$

# FIG.3B

$E(eV)$

1,9

1,8

1,7

1,6

1,5

1,4

0

$p = 1 \times 10^{18}$

$V_D = 0V$

$p = 1,5 \times 10^{17}$

$X = 0,3$

$E_C$

$E_V$

$F_1 = F_2$

$-0,01$   $-0,005$   $0$   $0,005$   $0,01$   $X(\mu m)$

2

## FIG.4A

$\Delta E_C$

$\Delta E'_C$

20

$E_F$

$GaAs(p^+)$

22

$Ga_{1-X}Al_XAs(N)$

$0\;L$          $W_H$

BASE          EMETTEUR

## FIG.4B

$Ga_{1-Y}Al_YAs$

$Y>X$

$GaAs(p^+)$

24          26

$E_F$

$Ga_{1-X}Al_XAs(N)$

BASE          EMETTEUR

FIG.5

$Ga_{1-y}Al_yAs(p^-)$

$Ga_{1-x}Al_xAs(N)$

$GaAs(p^+)$

$\Delta E_c \simeq 0,3\,eV$

$E_F$

28

jonction électronique

jonction métallurgique

Gradient Al

FIG.7

A

EMETTEUR
BASE
COLLECTEUR
Substrat
CONTACT

32

FIG.6

Zn

GaAlAs

E

GaAs

C    B

GaAs

Subst.

30

B

$(n)Ga_{1-x}Al_xAs$
$(p)\,GaAs$
$(n)\,GaAs$
$(n^+)GaAs$

E
B
C
S

C

E
B
C
S

D

E
B
C
S

# FIG.8A

CB          CC          CB

| ++++ ++ +++ | | ++++ +++ ++ |
|---|---|---|

$Coll.$          $(zn)\ p^+$

$Base$

$Em.$

$Subst.$

# FIG.8B

CC

CB          CB

$Coll.$

Base

$Em.$

$Subst.$